# EUROPEAN PATENT APPLICATION

(11) **EP 4 646 050 A1**
(43) Date of publication of application: **05.11.2025**
(21) Application number: 25167707.6
(22) Date of filing: 01.04.2025
(51) Int. Cl.: H10B 12/00

(54) **INTEGRATED CIRCUIT DEVICE AND METHOD OF MANUFACTURING THE SAME**

(30) Priority: 30.04.2024 KR 20240058135
(71) Applicant: Samsung Electronics Co., Ltd., Suwon-si, Gyeonggi-do 16677 (KR)
(72) Inventor: WON, Seokjae, 16677 Suwon-si, Gyeonggi-do (KR); KANG, Yoongoo, 16677 Suwon-si, Gyeonggi-do (KR); PARK, Jaehong, 16677 Suwon-si, Gyeonggi-do (KR); KIM, Doohee, 16677 Suwon-si, Gyeonggi-do (KR); KIM, Yeeju, 16677 Suwon-si, Gyeonggi-do (KR); KIM, Cheolho, 16677 Suwon-si, Gyeonggi-do (KR); AHN, Seojin, 16677 Suwon-si, Gyeonggi-do (KR)
(74) Representative: Kuhnen & Wacker Patent- und Rechtsanwaltsbüro PartG mbB

(57) **Abstract**

A method of manufacturing an integrated circuit device includes providing a substrate including a cell array area (MCA) and a peripheral circuit area (PCA); forming a conductive layer in the cell array area (MCA) and the peripheral circuit area (PCA); forming a capping insulating layer on the conductive layer; forming, in the cell array area (MCA), a direct contact (DC) and a bit line (BL) by using the capping insulating layer as a first etching mask; forming a spacer structure (150) on side walls of the direct contact (DC) and on side walls of the bit line (BL); forming a buried contact (BC) that is between the direct contact (DC) and the bit line (BL) and a first side wall of the side walls of the bit line (BL); forming an insulating spacer on the cell array area (MCA) and the peripheral circuit area (PCA); and forming, in the peripheral circuit area (PCA), a gate structure (PGT) by using the insulating spacer as a second etching mask.

## Description

### TECHNICAL FIELD

The present disclosure relates to an integrated circuit device and a method of manufacturing the same, and more particularly, to an integrated circuit device including a bit line and a method of manufacturing the integrated circuit device.

### BACKGROUND

As integrated circuit devices are downscaled, the size of individual microcircuit patterns for implementing integrated circuit devices has been reduced. Moreover, due to the high integration degree of integrated circuit devices, the width of bit lines has been decreased, and processes for forming a contact between bit lines have become more difficult.

### SUMMARY

The present disclosure provides an integrated circuit device having improved electrical characteristics and reliability and a method of manufacturing the same.

The technical task to be solved by the technical ideas of the present disclosure is not limited to the above-mentioned tasks, and other tasks that have not been mentioned may also be clearly understood by a person skilled in the art from the following descriptions.

According to an aspect of the present disclosure, there is provided a method of manufacturing an integrated circuit device, the method including providing a substrate including a cell array area and a peripheral circuit area; forming a conductive layer in the cell array area and the peripheral circuit area; forming a capping insulating layer on the conductive layer; forming, in the cell array area, a direct contact and a bit line by using the capping insulating layer as a first etching mask; forming a spacer structure on side walls of the direct contact and on side walls of the bit line; forming a buried contact that is between the direct contact and the bit line and a first side wall of the side walls of the bit line; forming an insulating spacer on the cell array area and the peripheral circuit area; and forming, in the peripheral circuit area, a gate structure by using the insulating spacer as a second etching mask.

According to another aspect of the present disclosure, there is provided a method of manufacturing an integrated circuit device, the method including providing a substrate including a cell array area and a peripheral circuit area; forming a conductive layer in the cell array area and the peripheral circuit area; forming a first capping layer including a single film on the conductive layer; forming, in the cell array area, a direct contact, a bit line, and a capping pattern that is on the bit line and the direct contact by using the first capping layer as a first etching mask; forming a spacer structure on side walls of the direct contact and on side walls of the bit line; forming a buried contact that is between the direct contact and is on a first side wall of the side walls of the bit line; forming an insulating spacer on the cell array area and the peripheral circuit area; and forming, in the peripheral circuit area, a gate structure by using the insulating spacer as a second etching mask.

According to another aspect of the present disclosure, a method of manufacturing an integrated circuit device includes providing a substrate; forming a buffer film on the substrate; forming a lower conductive layer on the buffer film; etching the lower conductive layer and the buffer film to define a direct contact hole; forming a direct contact in the direct contact hole; forming an intermediate conductive layer on the lower conductive layer and the direct contact; forming an upper conductive layer on the intermediate conductive layer; forming a first capping layer on the upper conductive layer; forming a mask layer on the first capping layer; patterning the first capping layer and the mask layer to form a mask pattern and a capping pattern, respectively; etching, using the mask pattern and the capping pattern as a first etching mask: the upper conductive layer, the intermediate conductive layer, and the lower conductive layer to form a bit line, and a portion of the direct contact to expose a portion of the direct contact hole; forming a spacer structure on the portion of the direct contact hole and on side walls of the bit line; forming a buried contact that is on a first side wall of the side walls of the bit line; removing the mask pattern to expose the capping pattern; forming an insulating spacer on the capping pattern, the spacer structure, and the buried contact; and forming a gate structure by using the insulating spacer as a second etching mask.

According to another aspect of the present disclosure, there is provided an integrated circuit device including a substrate including a cell array area and a peripheral circuit area, a bit line extending in a direction parallel with an upper surface of the substrate in the cell array area of the substrate, a direct contact connected to an active area of the substrate in a direct contact hole formed in the substrate, a buried contact arranged between the direct contact and the bit line and between adjacent bit lines, a spacer structure covering both side walls of the direct contact and the bit line, a first capping pattern covering the bit line and including a single film, an insulating spacer covering the first capping pattern and the buried contact, a gate structure arranged on the substrate in the peripheral circuit area of the substrate, and a contact plug arranged on a side of the gate structure.

### BRIEF DESCRIPTION OF THE DRAWINGS

Embodiments will be more clearly understood from the following detailed description taken in conjunction with the accompanying drawings in which:
FIG. 1 is a layout diagram of an integrated circuit device according to some embodiments;
FIG. 2 is an enlarged layout diagram of part II of FIG. 1;
FIG. 3A is a cross-sectional view taken along line A-A' of FIG. 2;
FIG. 3B is a cross-sectional view taken along line B-B' of FIG. 2;
FIG. 4 is an enlarged view of part EX1 of FIG. 3A;
FIGS. 5A to 11B are cross-sectional views illustrating a method of manufacturing an integrated circuit device according to an embodiment, wherein FIGS. 5A, 6, 7A, 8A, 9A, 10A, and 11A are cross-sectional views corresponding to the cross-section taken along the line A-A' of FIG. 2, and FIGS. 5B, 7B, 8B, 9B, 10B, and 11B are cross-sectional views corresponding to the cross-section taken along the line B-B' of FIG. 2; and
FIGS. 12A to 17B are cross-sectional views illustrating a method of manufacturing an integrated circuit device according to an embodiment, wherein FIGS. 12A, 13, 14A, 15A, 16A, and 17A are cross-sectional views corresponding to the cross-section taken along the line A-A' of FIG. 2, and FIGS.12B, 14B, 15B, 16B, and 17B are cross-sectional views corresponding to the cross-section taken along the line B-B' of FIG. 2.

### DETAILED DESCRIPTION

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. The term "exposed" may be used to define a relationship between particular layers or surfaces, but it does not require the layer or surface to be free of other elements or layers thereon in the completed device.

Hereinafter, embodiments of the technical idea of the present disclosure will be described in detail with reference to the accompanying drawings. Like reference numerals in the drawings denote like elements, and any redundant description will be omitted.

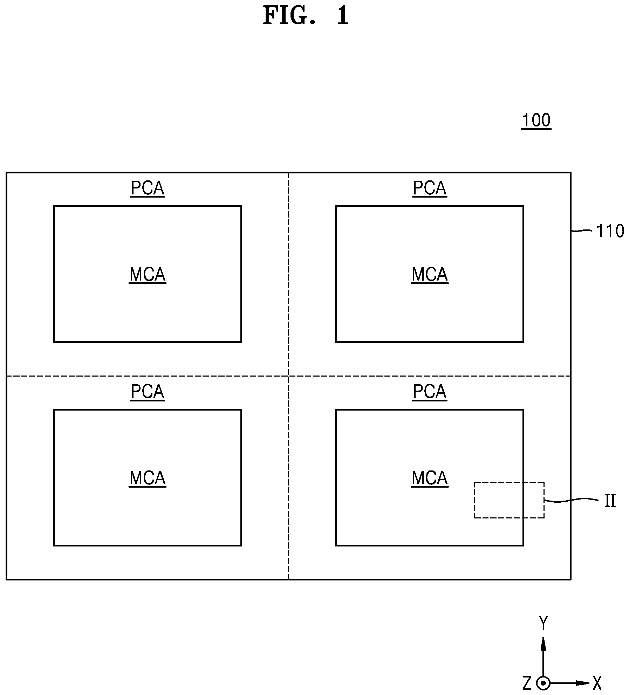

FIG. 1 is a layout diagram of an integrated circuit device according to an embodiment.

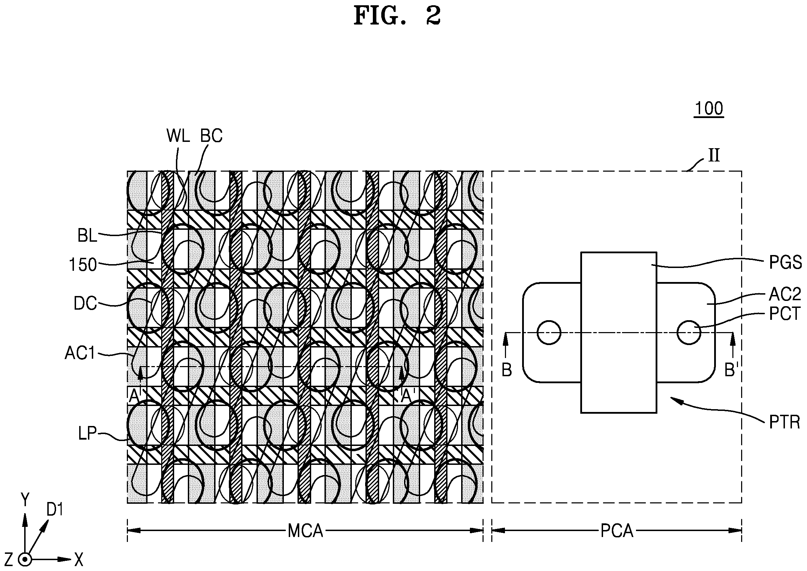

FIG. 2 is an enlarged layout diagram of part II of FIG. 1.

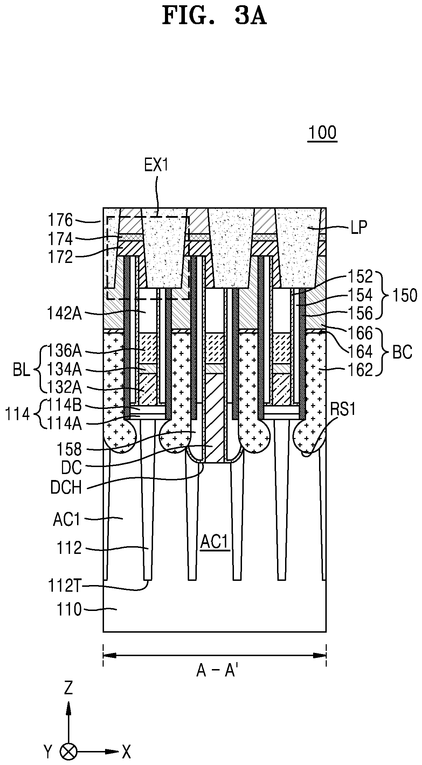

FIG. 3A is a cross-sectional view taken along the line A-A' of FIG. 2.

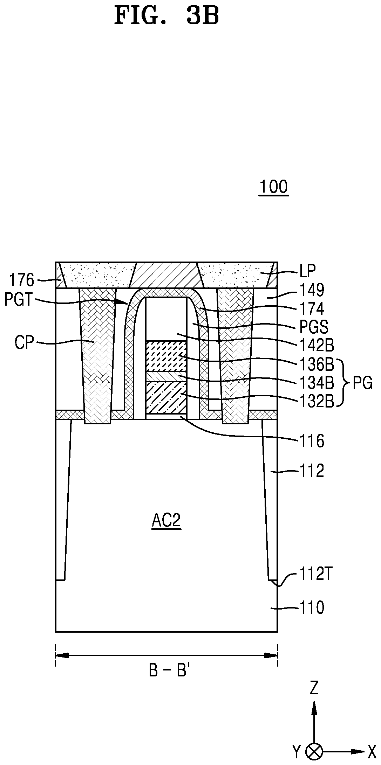

FIG. 3B is a cross-sectional view taken along the line B-B' of FIG. 2.

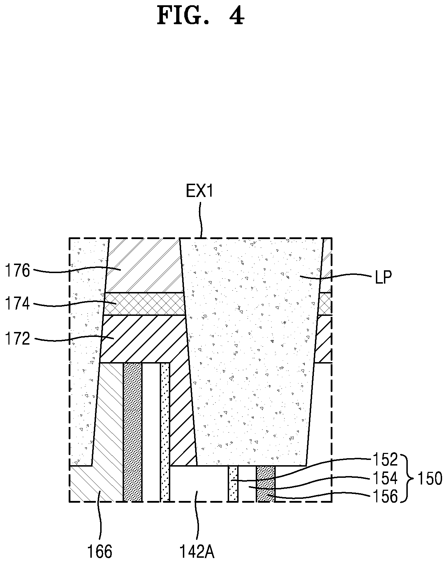

FIG. 4 is an enlarged view of the part EX1 of FIG. 3A.

Referring to FIGS. 1 to 4, an integrated circuit device 100 may include a substrate 110 including a cell array area MCA and a peripheral circuit area PCA. A device isolation trench 112T may be formed in the substrate 110, and a device isolation film 112 may be formed in the device isolation trench 112T. In the cell array area MCA, a plurality of first active areas AC1 may be defined in the substrate 110 by the device isolation film 112, and in the peripheral circuit area PCA, a second active area AC2 may be defined in the substrate 110 by the device isolation film 112.

The plurality of first active areas AC1 of the substrate 110 in the cell array area MCA may each be arranged to have a major axis in a diagonal direction D1 with respect to a first direction X and a second direction Y. In the cell array area MCA of the substrate 110, a plurality of word lines WL may cross or intersect the plurality of first active areas AC1 and may be arranged to be parallel with each other in the first direction X. On the plurality of word lines WL, a plurality of bit lines BL may extend in parallel with each other in the second direction Y. The plurality of bit lines BL may be arranged in the cell array area MCA. The plurality of bit lines BL may be connected to the plurality of first active areas AC1 through a direct contact DC.

In the specification, the first direction X may be defined as a direction that is parallel with an upper surface of the substrate 110, the second direction Y may be defined as a direction that is parallel with the upper surface of the substrate 110 and intersects the first direction X, and a vertical direction Z may be defined as a direction that is perpendicular to the upper surface of the substrate 110.

A plurality of buried contacts BC may be formed between two adjacent bit lines BL among the plurality of bit lines BL. The plurality of buried contacts BC may be arranged in line in the first direction X and the second direction Y. A plurality of landing pads LP may be formed on the plurality of buried contacts BC. The plurality of buried contacts BC and the plurality of landing pads LP may serve to connect a lower electrode (not shown) of a capacitor formed on the plurality of bit lines BL to the first active areas AC1. Each of the plurality of landing pads LP may be arranged to partially overlap the buried contact BC.

The substrate 110 may include silicon, for example, single crystalline silicon, polycrystalline silicon, or amorphous silicon. In other embodiments, the substrate 110 may include at least one selected from Ge, SiGe, SiC, GaAs, InAs, and InP. In some embodiments, the substrate 110 may include a conductive area, for example, a well doped with impurities or a structure doped with impurities. The device isolation film 112 may include an oxide film, a nitride film, or a combination thereof.

In the cell array area MCA, a buffer film 114 may be formed on the substrate 110. The buffer film 114 may include a first insulating film 114A and a second insulating film 114B. The first insulating film 114A and the second insulating film 114B may each include an oxide film, a nitride film, or a combination thereof.

A plurality of direct contacts DC may be formed in a plurality of direct contact holes DCH on the substrate 110. The plurality of direct contacts DC may be connected to the plurality of first active areas AC1. The plurality of direct contacts DC may include doped polysilicon. For example, the plurality of direct contacts DC may include polysilicon including n-type impurities, such as phosphorous (P), arsenic (As), bismuth (Bi), and antimony (Sb) at a relatively high concentration.

The plurality of bit lines BL may extend in the second direction Y on the substrate 110 and the plurality of direct contacts DC. Each of the plurality of bit lines BL may be connected to the first active area AC1 through the direct contact DC. The plurality of bit lines BL may each include a lower conductive pattern 132A, an intermediate conductive pattern 134A, and an upper conductive pattern 136A, which are sequentially stacked on the substrate 110. The lower conductive pattern 132A may include doped polysilicon. The intermediate conductive pattern 134A and the upper conductive pattern 136A may each include TiN, TiSiN, W, tungsten silicide, or a combination thereof. In some embodiments, the intermediate conductive pattern 134A may include TiN, TiSiN, or a combination thereof, and the upper conductive pattern 136A may include W.

The plurality of bit lines BL may be covered with a plurality of first capping patterns 142A. The first capping pattern 142A may include one of an oxide, a nitride, and an oxynitride. The plurality of first capping patterns 142A may extend on the plurality of bit lines BL in the second direction Y. The first capping pattern 142A arranged on the bit line BL may not form an interface and may include a single film.

As described below, as the first capping pattern 142A does not form an interface (unlike a second capping layer 174 described below), deterioration of the bit lines BL caused in the process of forming a gate structure PGT and the second capping layer 174 covering or on the gate structure PGT may be prevented or inhibited to improve the characteristics of the integrated circuit device 100.

A spacer structure 150 may be arranged on first and second side walls (collectively referred to as "both side walls") of each of the plurality of bit lines BL. The spacer structure 150 may extend in the second direction Y on both side walls of the plurality of bit lines BL, and a part of the spacer structure 150 may extend into the direct contact hole DCH to cover or be on both side walls of the direct contact DC.

In some embodiments, the spacer structure 150 may include a first spacer layer 152, a second spacer layer 154, and a third spacer layer 156. The first spacer layer 152 may be arranged conformally on side walls of the plurality of bit lines BL, side walls of the plurality of first capping patterns 142A, and an inner wall of the direct contact hole DCH. The second spacer layer 154 and the third spacer layer 156 may be sequentially arranged on the first spacer layer 152. In some embodiments, the first spacer layer 152 and the third spacer layer 156 may include a silicon nitride, and the second spacer layer 154 may include a silicon oxide. In some embodiments, the first spacer layer 152 and the third spacer layer 156 may include a silicon nitride, and the second spacer layer 154 may include air or a low-k dielectric material. In this regard, the term "air" may refer to a space including the atmosphere or other gases that may be present in a manufacturing process.

A buried insulating layer 158 may surround at least a portion of a lower side wall of the direct contact DC on the first spacer layer 152 and may fill at least a portion of a remaining space of the direct contact hole DCH. The buried insulating layer 158 may include a silicon nitride, a silicon oxynitride, a silicon oxide, or a combination thereof.

The direct contact DC may be formed in the direct contact hole DCH formed in the substrate 110 and may extend to a level in the vertical direction Z relative to a lower surface of the substrate 110 that is higher than a level of the upper surface of the substrate 110 in the vertical direction Z relative to the lower surface of the substrate 110. For example, an upper surface of the direct contact DC may be arranged at the same level (e.g., coplanar) as an upper surface of the lower conductive pattern 132A, and the upper surface of the direct contact DC may be in contact with a bottom surface of the intermediate conductive pattern 134A. In addition, the bottom surface of the direct contact DC may be arranged at a lower level in the vertical direction Z relative to the lower surface of the substrate 110 than a level of the upper surface of the substrate 110 in the vertical direction Z relative to the lower surface of the substrate 110.

A plurality of insulating fences (not shown) and the plurality of buried contacts BC may be arranged in line in the second direction Y between the plurality of bit lines BL. The plurality of buried contacts BC may each include a lower contact conductive layer 162, a metal silicide film 164, and an upper contact conductive layer 166.

The plurality of buried contacts BC may extend in the vertical direction Z from a first recess space RS1 formed in the substrate 110. In the second direction Y, both side walls of each of the plurality of buried contacts BC may be insulated by a plurality of insulating fences. The plurality of insulating fences may include a silicon nitride film.

In some embodiments, the lower contact conductive layer 162 may include doped polysilicon. The metal silicide film 164 may include cobalt silicide, nickel silicide, or manganese silicide. The upper contact conductive layer 166 may include Ti, TiN, or a combination thereof. In some embodiments, the plurality of buried contacts BC may include Ti, TiN, Ta, TaN, Ru, Co, Mo, W, WN, TiSiN, WSiN, cobalt silicide, nickel silicide, tungsten silicide, or a combination thereof.

In some embodiments, a level of an upper surface of the buried contact BC in the vertical direction Z relative to the lower surface of the substrate 110 may be different from a level of an upper surface of the first capping pattern 142A in the vertical direction Z relative to the lower surface of the substrate 110. For example, the level of the upper surface of the buried contact BC may be higher than the level of the upper surface of the first capping pattern 142A.

An insulating spacer 172 may cover or be on the buried contact BC, the spacer structure 150, and the first capping pattern 142A. In this regard, the insulating spacer 172 may be formed to be stepped or have a stepped shape. A level of a lower surface of the insulating spacer 172 in contact with the buried contact BC in the vertical direction Z relative to the lower surface of the substrate 110 may be different from a level of a lower surface of the insulating spacer 172 in contact with the first capping pattern 142A in the vertical direction Z relative to the lower surface of the substrate 110. For example, the insulating spacer 172 may have an L-shape. In some embodiments, the insulating spacer 172 may include a silicon nitride, a silicon oxynitride, a silicon oxide, or a combination thereof.

The second capping layer 174 and an upper insulating layer 176 may be sequentially arranged on the insulating spacer 172. The second capping layer 174 and the upper insulating layer 176 may include a silicon nitride, a silicon oxynitride, a silicon oxide, or a combination thereof.

The plurality of landing pads LP may be formed on the plurality of buried contacts BC. The landing pad LP may pass through or extend into the insulating spacer 172, the second capping layer 174, and the upper insulating layer 176. The landing pad LP may be arranged to vertically overlap the buried contact BC. Although FIG. 3A illustrates that a lower surface of the landing pad LP may be coplanar with the lower surface of the insulating spacer 172, the present disclosure is not limited thereto.

The landing pad LP may be connected to the buried contact BC. The landing pad LP may include a metal, a metal nitride, conductive polysilicon, or a combination thereof. For example, the landing pad LP may include W. The plurality of landing pads LP may have a pattern shape of a plurality of islands, ellipses, and/or circles in plan view. The plurality of landing pads LP may have a horizontal cross-sectional area which increases as a distance from the landing pads LP to the substrate 110 increases in the vertical direction Z.

The plurality of landing pads LP may cover or be on a side wall of the insulating spacer 172 and an upper surface of the first capping pattern 142A to vertically overlap a part of the plurality of bit lines BL. The plurality of landing pads LP may be electrically insulated by the upper insulating layer 176, the second capping layer 174, and the insulating spacer 172 around the plurality of landing pads LP.

In the peripheral circuit area PCA, the gate structure PGT may be arranged on the second active area AC2. The gate structure PGT may include a gate dielectric film 116, a peripheral circuit gate electrode PG, and a gate capping pattern 142B, which are sequentially stacked on the second active area AC2.

The gate dielectric film 116 may include at least one selected from a silicon oxide film, a silicon nitride film, a silicon oxynitride film, ONO (oxide/ nitride/oxide), and a high-k dielectric film having a higher dielectric constant than a silicon oxide film. The peripheral circuit gate electrode PG may include a lower conductive pattern 132B, an intermediate conductive pattern 134B, and an upper conductive pattern 136B. The constituent materials of the lower conductive pattern 132B, the intermediate conductive pattern 134B, and the upper conductive pattern 136B may respectively be the same as the constituent materials of the lower conductive pattern 132A, the intermediate conductive pattern 134A, and the upper conductive pattern 136A, which are included in the bit line BL in the cell array area MCA. The gate capping pattern 142B may include a silicon nitride film.

Both side walls of the gate structure PGT may be covered or overlapped by a gate spacer PGS. The gate spacer PGS may include an oxide film, a nitride film, or a combination thereof. The gate structure PGT and the gate spacer PGS may be covered or overlapped by the second capping layer 174. The second capping layer 174 may include a silicon nitride film. An interlayer insulating film 149 may be formed on the second capping layer 174 and around the gate structure PGT. The interlayer insulating film 149 may include TOSZ (Tonen SilaZene); however, the present disclosure is not limited thereto. The gate structure PGT, the second capping layer 174, and the interlayer insulating film 149 may be covered or overlapped by the upper insulating layer 176. The upper insulating layer 176 may include a silicon nitride film.

In the peripheral circuit area PCA, a plurality of contact plugs CP which pass through or extend into the interlayer insulating film 149 and the second capping layer 174 in the vertical direction Z to extend to the second active area AC2 of the substrate 110. The plurality of contact plugs CP may be arranged on both sides of the gate structure PGT. The contact plug CP may be identical to the buried contact BC formed in the cell array area MCA. The contact plug CP may include Ti, TiN, or a combination thereof. Although it is not shown in the drawings, a metal silicide film (not shown) may be arranged between the second active area AC2 and the contact plug CP. The metal silicide film may include cobalt silicide, nickel silicide, or manganese silicide.

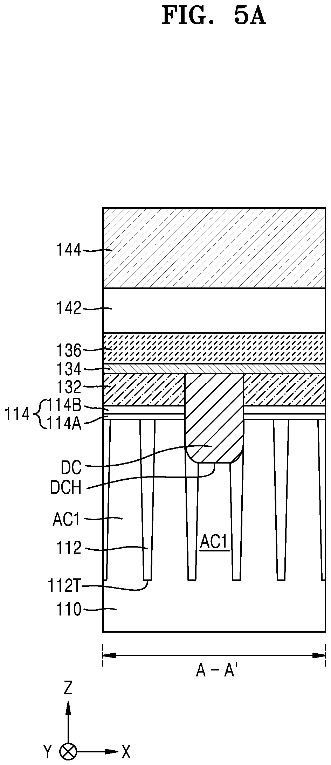

FIGS. 5A to 11B are cross-sectional views illustrating a method of manufacturing the integrated circuit device 100 according to an embodiment. More specifically, FIGS. 5A, 6, 7A, 8A, 9A, 10A, and 11A are cross-sectional views corresponding to the cross-section taken along the line A-A' of FIG. 2, and FIGS. 5B, 7B, 8B, 9B, 10B, and 11B are cross-sectional views corresponding to the cross-section taken along the line B-B' of FIG. 2.

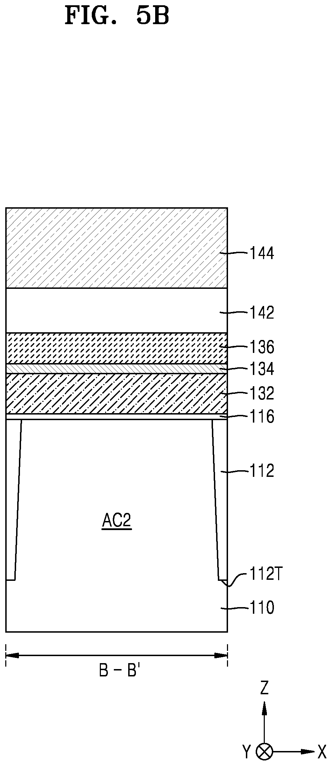

Referring to FIGS. 5A and 5B, in the cell array area MCA, the buffer film 114 including the first insulating film 114A and the second insulating film 114B may be formed on the substrate 110, and in the peripheral circuit area PCA, the gate dielectric film 116 may be formed on the substrate 110.

Afterwards, a lower conductive layer 132 may be formed on the buffer film 114 in the cell array area MCA and on the gate dielectric film 116 in the peripheral circuit area PCA. In some embodiments, the lower conductive layer 132 may include Si, Ge, W, WN, Co, Ni, Al, Mo, Ru, Ti, TiN, Ta, TaN, Cu, or a combination thereof. For example, the lower conductive layer 132 may include polysilicon.

After a first mask pattern (not shown) is formed on the lower conductive layer 132, by etching the buffer film 114 and the lower conductive layer 132 exposed through an opening (not shown) of the first mask pattern in the cell array area MCA and etching a part of the substrate 110 and a part of the device isolation film 112, which are exposed as a result, the direct contact hole DCH exposing the first active area AC1 of the substrate 110 may be formed.

Then, the first mask pattern may be removed, and the direct contact DC may be formed in the direct contact hole DCH. In a process for forming the direct contact DC, a conductive layer having a thickness that is sufficient to at least partially fill the direct contact hole DCH may be formed in the direct contact hole DCH and on the lower conductive layer 132, and an etch back process may be performed on the conductive layer such that the conductive layer is left only in the direct contact hole DCH. The conductive layer may include polysilicon.

Then, in the cell array area MCA and the peripheral circuit area PCA, an intermediate conductive layer 134, an upper conductive layer 136, and a capping insulating layer may be sequentially formed on the lower conductive layer 132 and the direct contact DC. The capping insulating layer may include a first capping layer 142 and a mask layer 144. The intermediate conductive layer 134 and the upper conductive layer 136 may each include TiN, TiSiN, W, tungsten silicide, or a combination thereof.

In some embodiments, the first capping layer 142 and the mask layer 144 may include materials having etching selectivity with respect to each other. The first capping layer 142 and the mask layer 144 may include an oxide, a nitride, an oxynitride, or a combination thereof. For example, the first capping layer 142 and the mask layer 144 may include SiO₂, SiN, ZrO, HfO, or a combination thereof.

In a method of manufacturing the integrated circuit device 100 according to the present disclosure, after a process of forming the buried contacts BC and a process of forming the bit lines BL of the cell array area MCA, a process of forming the gate structure PGT of the peripheral circuit area PCA may be performed. Accordingly, the height of the capping insulating layer may be designed by considering the process of buried contacts BC and the process of bit lines BL of the cell array area MCA. That is, the height of the capping insulating layer in the vertical direction Z relative to the lower surface of the substrate 110 may be reduced. For example, the height of the capping insulating layer may be reduced by about 43 % as compared to the height of the capping insulating layer of a conventional integrated circuit device, and accordingly, the process difficultly may decrease. For example, by reducing the height of the capping insulating layer used as an etching mask, the line width roughness (LWR), aspect ratio, etc. may be improved, which leads to a decreased process difficulty.

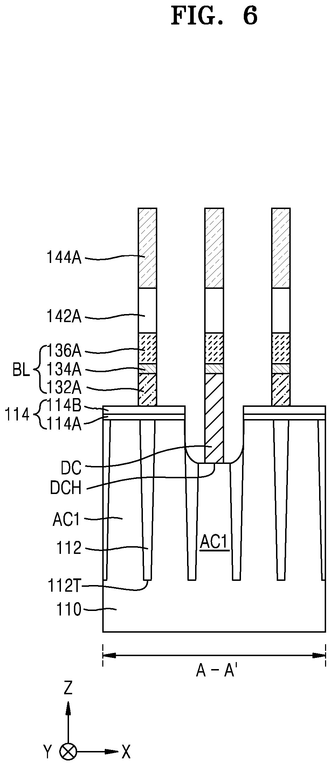

Referring to FIG. 6, by patterning the first capping layer 142 and the mask layer 144 in the cell array area MCA, a mask pattern 144A and the first capping pattern 142A may be formed. In the process, the height of the mask pattern 144A in the vertical direction Z relative to the lower surface of the substrate 110 may be reduced to be less than the height of the mask layer 144 in the vertical direction Z relative to the lower surface of the substrate 110 (FIG. 5A). By using the mask pattern 144A and the first capping pattern 142A as an etching mask, the upper conductive layer 136, the intermediate conductive layer 134, and the lower conductive layer 132 may be etched to form the plurality of bit lines BL including the lower conductive pattern 132A, the intermediate conductive patter 134A, and the upper conductive pattern 136A. In the process of forming the plurality of bit lines BL, the side wall of the direct contact DC may be partially removed, and a part of the direct contact hole DCH may be exposed.

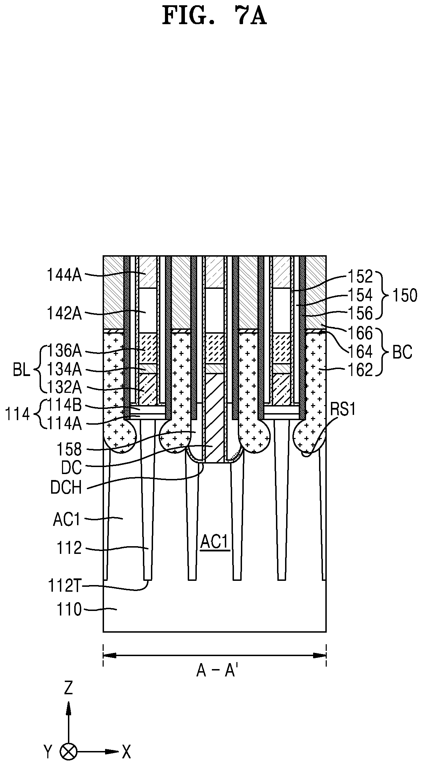

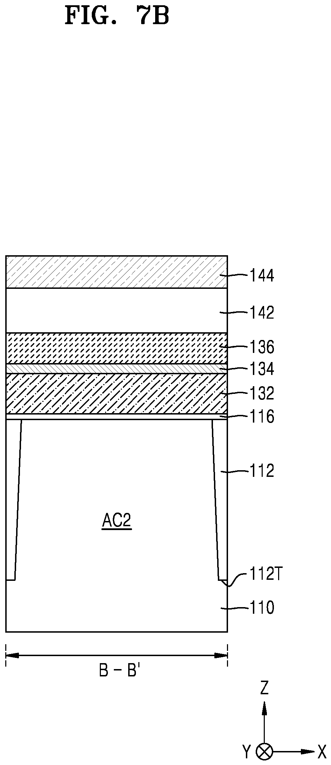

Referring to FIGS. 7A and 7B, the spacer structure 150 may be formed on the side walls of the plurality of bit lines BL and the direct contacts DC. The spacer structure 150 may include the first spacer layer 152, the second spacer layer 154, and the third spacer layer 156. In the process, the buried insulating layer 158 at least partially filling the inside of the direct contact hole DCH may be formed.

In addition, by partially removing the substrate 110, the plurality of first recess spaces RS1 exposing the first active area AC1 of the substrate 110 between the plurality of bit lines BL may be formed. The plurality of buried contacts BC at least partially filling the plurality of first recess spaces RS1 and spaces between the plurality of bit lines BL may be formed. The plurality of buried contacts BC may each include the lower contact conductive layer 162, the metal silicide film 164, and the upper contact conductive layer 166.

In the process, an upper portion of the spacer structure 150 and an upper portion of the mask pattern 144A covering or on the bit line BL may be removed as well, and accordingly, the level of the mask pattern 144A in the vertical direction Z relative to the lower surface of the substrate 110 may be lowered. Then, in the cell array area MCA, the upper surface of the mask pattern 144A and the upper surface of the buried contact BC may form the same plane (e.g., the upper surface of the mask pattern 144A and the upper surface of the buried contact BC may be coplanar).

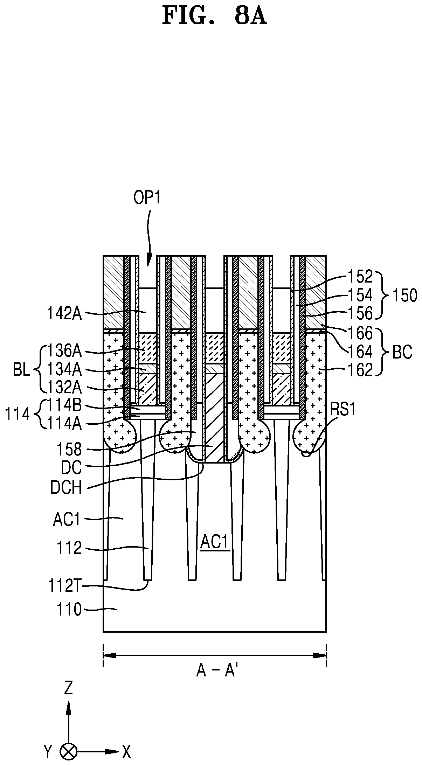

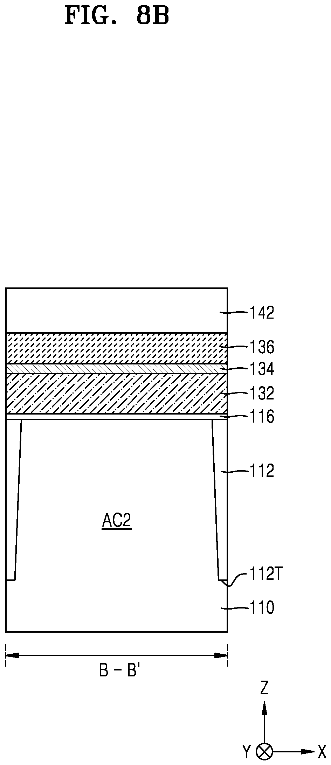

Referring to FIGS. 8A and 8B, in the cell array area MCA and the peripheral circuit area PCA, the mask layer 144 and the mask pattern 144A may be removed. Accordingly, the upper surface of the first capping pattern 142A may be exposed in the cell array area MCA, and the upper surface of the first capping layer 142 may be exposed in the peripheral circuit area PCA. As the upper surface of the first capping pattern 142A is exposed in the cell array area MCA, a first opening OP1 may be formed in the bit line BL.

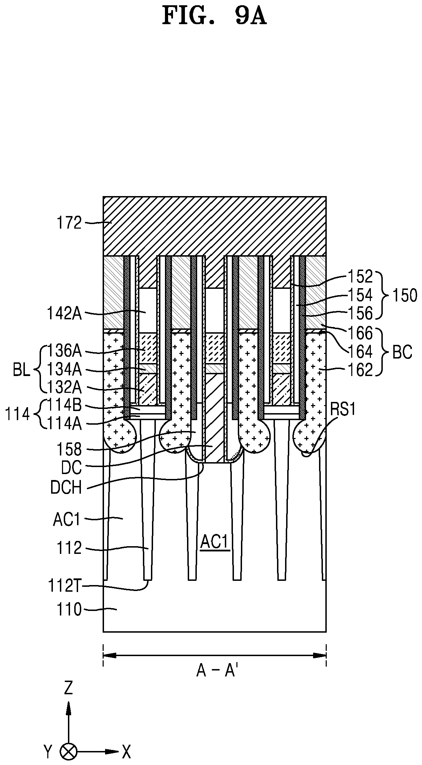

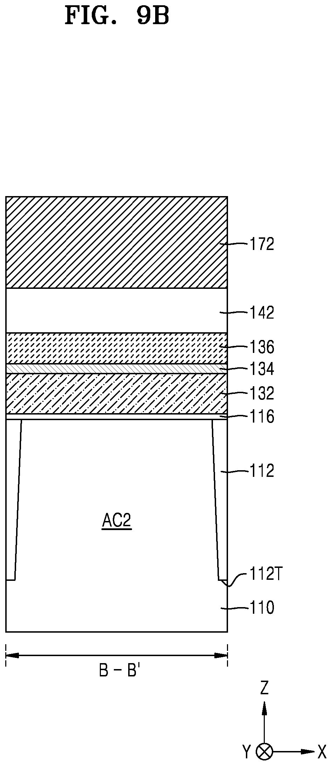

Referring to FIGS. 9A and 9B, the insulating spacer 172 covering or on the cell array area MCA and the peripheral circuit area PCA may be formed. In the cell array area MCA, the insulating spacer 172 may fill at least a portion of the first opening OP1 (FIG. 8A). In the cell array area MCA and the peripheral circuit area PCA, the insulating spacer 172 may conformally cover the first capping pattern 142A and the first capping layer 142.

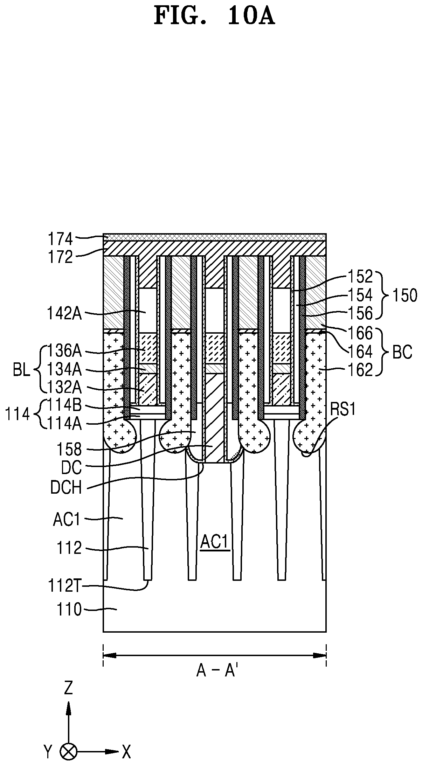

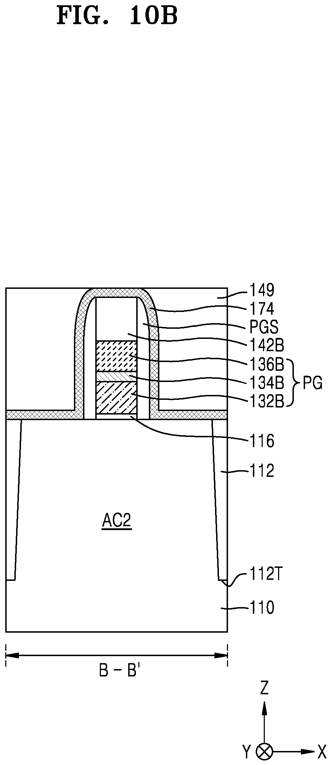

Referring to FIGS. 10A and 10B, by using the insulating spacer 172 as an etching mask in the peripheral circuit area PCA, the gate dielectric film 116, the lower conductive layer 132, the intermediate conductive layer 134, the upper conductive layer 136, and a lower capping layer 142 may be patterned to form a gate electrode PG including the lower conductive pattern 132B, the intermediate conductive pattern 134B, and the upper conductive pattern 136B on the gate dielectric film 116 and the gate capping pattern 142B covering or on the gate electrode PG may be formed. Then, the gate spacer PGS may be formed on both side walls of the gate structure PGT having a stacked structure of the gate dielectric film 116, the gate electrode PG, and the gate capping pattern 142B, and an ion implantation process for forming a source/drain region in the second active area AC2 may be performed on both sides of the gate structure PGT. In the process, the level of the insulating spacer 172 of the cell array area MCA in the vertical direction Z relative to the lower surface of the substrate 110 may be lowered.

Afterwards, the second capping layer 174 which covers or is on the insulating spacer 172 in the cell array area MCA and covers or is on the gate structure PGT and the gate spacer PGS in the peripheral circuit area PCA may be formed. Then, the interlayer insulating film 149 filling at least a portion of a peripheral space around the gate structure PGT in the peripheral circuit area PCA may be formed.

In this regard, the insulating spacer 172 may be formed to be stepped or have a stepped shape. The level of the lower surface of the insulating spacer 172 in contact with the buried contact BC in the vertical direction Z relative to the lower surface of the substrate 110 may be different from the level of the lower surface of the insulating spacer 172 in contact with the first capping pattern 142A in the vertical direction Z relative to the lower surface of the substrate 110. In some embodiments, the insulating spacer 172 may include a silicon nitride, a silicon oxynitride, a silicon oxide, or a combination thereof.

In some embodiments, as the process of forming the second capping layer 174 is performed after the process of forming the bit lines BL, deterioration of the bit lines BL caused in the process of forming the gate structure PGT and the second capping layer 174 covering or on the gate structure PGT may be prevented or inhibited, which may improve the characteristics of the integrated circuit device 100.

In addition, as the process of forming the gate structure PGT is performed after the annealing process of the buried contacts BC, the heat budget may decrease, and accordingly, the characteristics of the integrated circuit device 100 may be improved.

Moreover, in the process of forming the gate structure PGT, the second capping layer 174 formed in the cell array area MCA may be used as an etching mask in the process for the landing pads LP.

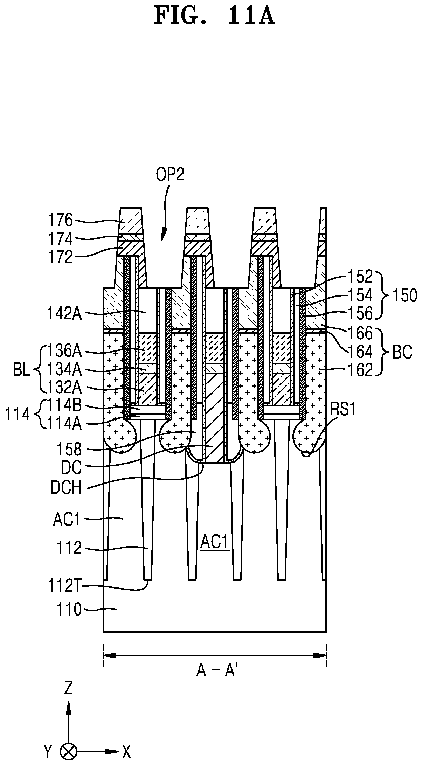

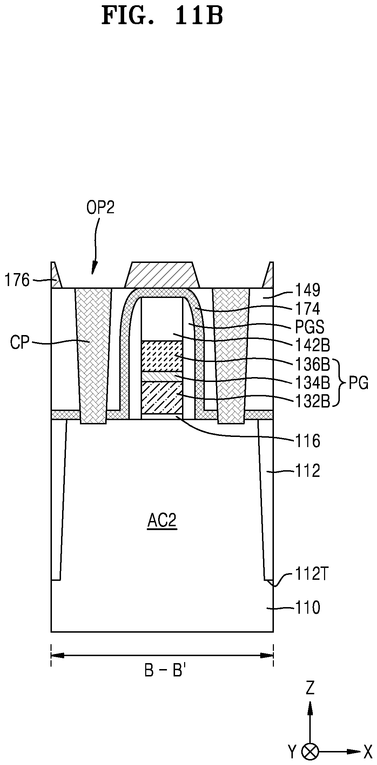

Referring to FIGS. 11A and 11B, by etching the second capping layer 174 and the interlayer insulating film 149 in the peripheral circuit area PCA, a plurality of contact holes CPH exposing the second active area AC2 of the substrate 110 may be formed, and the plurality of contact plugs CP at least partially filling the plurality of contact holes CPH may be formed.

Then, in the cell array area MCA and the peripheral circuit area PCA, the upper insulating layer 176 covering or on the second capping layer 174 may be formed. Afterwards, a second opening OP2 passing through or extending into the upper insulating layer 176, the second capping layer 174, and the insulating spacer 172 may be formed. In the cell array area MCA, the second opening OP2 may partially expose the buried contact BC.

Referring to FIGS. 3A and 3B, the landing pad LP filling at least a portion of the second opening OP2 may be formed. A damascene process may be used as the process of forming the landing pads LP; however, the present disclosure is not limited thereto. The plurality of landing pads LP may be arranged in the shape of an island, ellipse, and/or circle and may be connected to each of the plurality of buried contacts BC.

According to some embodiments of the present disclosure, as the process of forming the gate structure PGT is performed after the process of forming the buried contacts BC and the bit lines BL, the electrical characteristics and reliability of the integrated circuit device 100 may be improved.

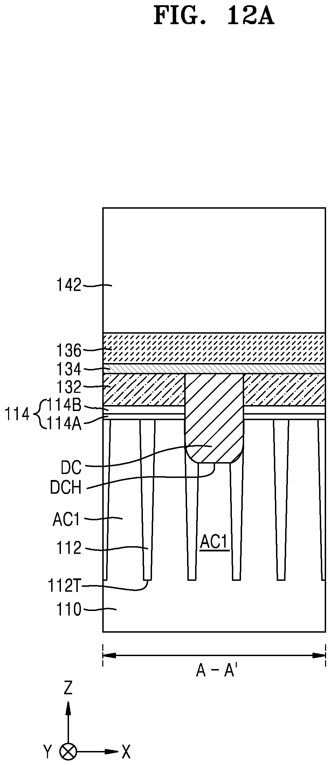

FIGS. 12A to 17B are cross-sectional views illustrating a method of manufacturing the integrated circuit device 100 according to an embodiment. More specifically, FIGS. 12A, 13, 14A, 15A, 16A, and 17A are cross-sectional views corresponding to the cross-section taken along the line A-A' of FIG. 2, and FIGS. 12B, 14B, 15B, 16B, and 17B are cross-sectional views corresponding to the cross-section taken along the line B-B' of FIG. 2. As the embodiments illustrated in FIGS. 12A to 17B are substantially identical to the embodiments illustrated in FIGS. 3A to 11B, the present disclosure is to be described focusing on the differences.

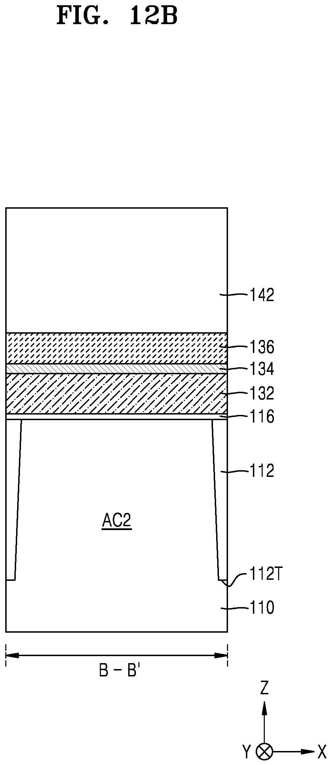

Referring to FIGS. 12A and 12B, in the cell array area MCA, the buffer film 114 including the first insulating film 114A and the second insulating film 114B may be formed on the substrate 110, and in the peripheral circuit area PCA, the gate dielectric film 116 may be formed on the substrate 110. Afterwards, the lower conductive layer 132 may be formed on the buffer film 114 in the cell array area MCA and on the gate dielectric film 116 in the peripheral circuit area PCA.

Then, by partially etching the substrate 110 and the device isolation film 112, the direct contact hole DCH exposing the first active area AC1 of the substrate 110 may be formed. The direct contact DC may be formed in the direct contact hole DCH.

Then, in the cell array area MCA and the peripheral circuit area PCA, an intermediate conductive layer 134, an upper conductive layer 136, and the first capping layer 142 may be sequentially formed on the lower conductive layer 132 and the direct contact DC. The intermediate conductive layer 134 and the upper conductive layer 136 may each include TiN, TiSiN, W, tungsten silicide, or a combination thereof.

In some embodiments, the first capping layer 142 may include a single film. The first capping layer 142 may include an oxide, a nitride, an oxynitride, or a combination thereof. For example, the first capping layer 142 may include SiO₂, SiN, ZrO, HfO, or a combination thereof.

In the method of manufacturing the integrated circuit device 100 according to the present disclosure, after the process of forming the buried contacts BC and the process of forming the bit lines BL of the cell array area MCA, the process of forming the gate structure PGT of the peripheral circuit area PCA may be performed. Accordingly, the height of the first capping layer 142 may be designed by considering the process of buried contacts BC and the process of bit lines BL of the cell array area MCA. That is, the height of the first capping layer 142 in the vertical direction Z relative to the lower surface of the substrate 110 may be adjusted to be less than the height of the capping insulating layer of a conventional integrated circuit device. For example, the height of the first capping layer 142 may be reduced by about 43 % as compared to the height of the capping insulating layer of a conventional integrated circuit device, and accordingly, the process difficultly may decrease. For example, by reducing the height of the first capping layer 142 used as an etching mask, the line width roughness (LWR), aspect ratio, etc. may be improved, which leads to a decreased process difficulty.

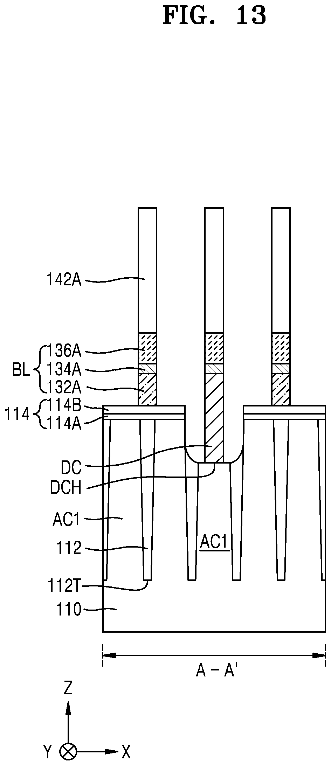

Referring to FIG. 13, by patterning the first capping layer 142 in the cell array area MCA, the first capping pattern 142A may be formed. In the process, the height of the first capping pattern 142A may be reduced to be lower than the height of the first capping layer 142 (FIG. 12A). By using the first capping pattern 142A as an etching mask, the upper conductive layer 136, the intermediate conductive layer 134, and the lower conductive layer 132 may be etched to form the plurality of bit lines BL including the lower conductive pattern 132A, the intermediate conductive pattern 134A, and the upper conductive pattern 136A. In the process of forming the plurality of bit lines BL, the side wall of the direct contact DC may be partially removed, and a part of the direct contact hole DCH may be exposed.

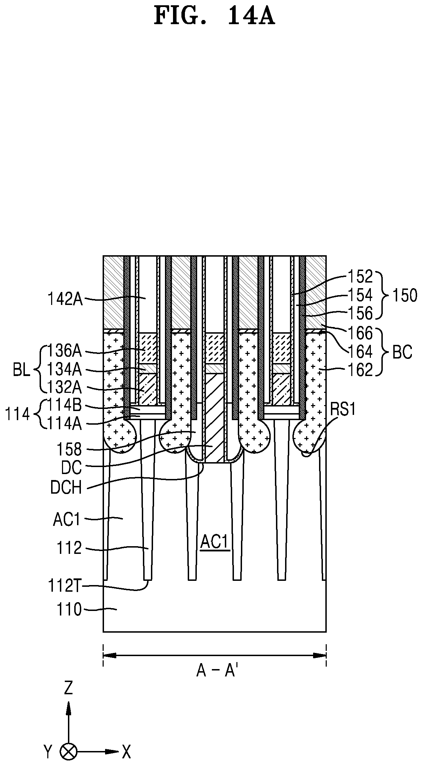

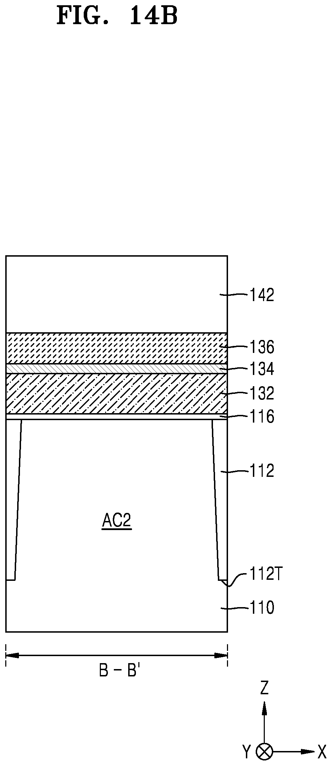

Referring to FIGS. 14A and 14B, the spacer structure 150 may be formed on the side walls of the plurality of bit lines BL and the direct contacts DC. The spacer structure 150 may include the first spacer layer 152, the second spacer layer 154, and the third spacer layer 156. In the process, the buried insulating layer 158 filling at least a portion of the inside of the direct contact hole DCH may be formed.

In addition, by partially removing the substrate 110, the plurality of first recess spaces RS1 exposing the first active area AC1 of the substrate 110 between the plurality of bit lines BL may be formed. The plurality of buried contacts BC filling at least a portion of the plurality of first recess spaces RS1 and spaces between the plurality of bit lines BL may be formed. The plurality of buried contacts BC may each include the lower contact conductive layer 162, the metal silicide film 164, and the upper contact conductive layer 166.

In the process, an upper portion of the spacer structure 150 and an upper portion of the first capping pattern 142A covering or on the bit line BL may be removed as well, and accordingly, the level of the first capping pattern 142A in the vertical direction Z relative to the lower surface of the substrate 110 may be lowered. Then, in the cell array area MCA, the upper surface of the first capping pattern 142A and the upper surface of the buried contact BC may form the same plane and thus be coplanar.

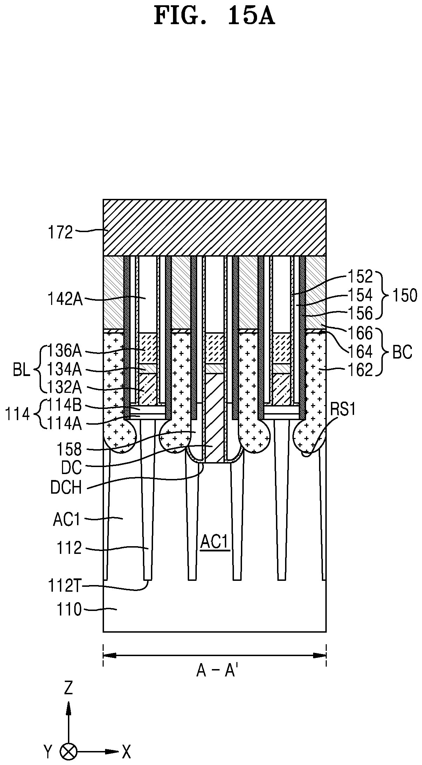

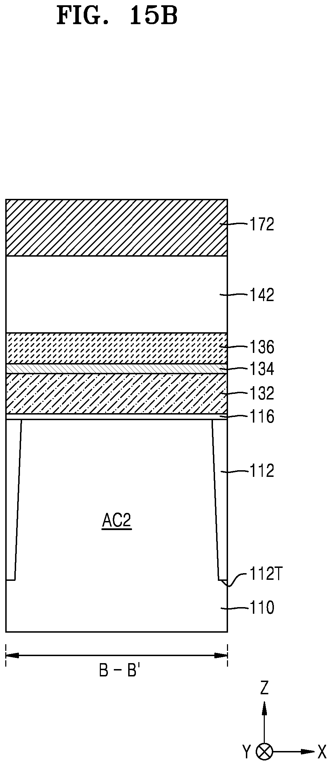

Referring to FIGS. 15A and 15B, the insulating spacer 172 covering or on the cell array area MCA and the peripheral circuit area PCA may be formed. In the cell array area MCA and the peripheral circuit area PCA, the insulating spacer 172 may conformally cover the first capping pattern 142A and the first capping layer 142.

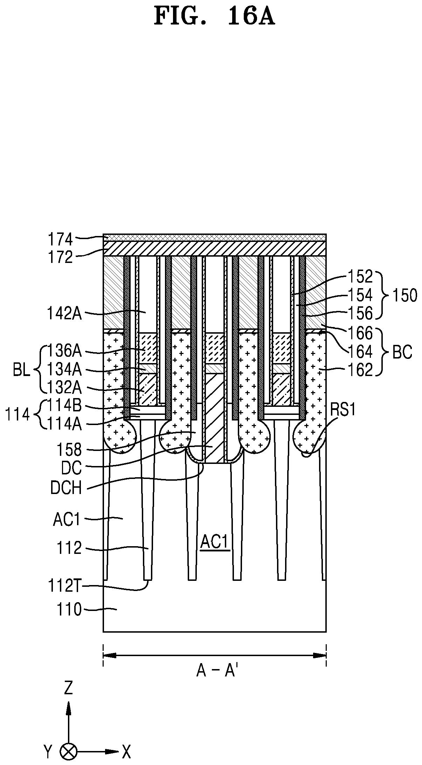

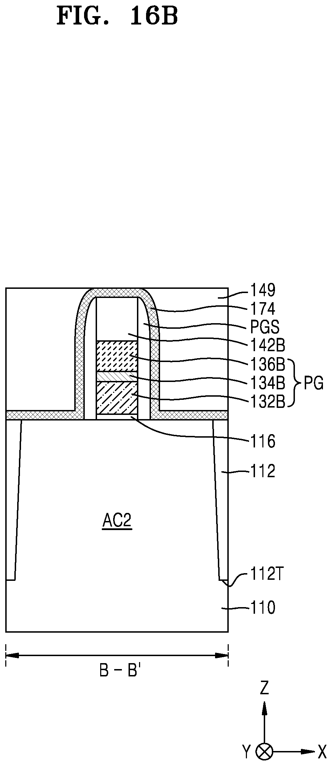

Referring to FIGS. 16A and 16B, by using the insulating spacer 172 as an etching mask in the peripheral circuit area PCA, the gate dielectric film 116, the lower conductive layer 132, the intermediate conductive layer 134, the upper conductive layer 136, and the lower capping layer 142 may be patterned to form the gate electrode PG including the lower conductive pattern 132B, the intermediate conductive pattern 134B, and the upper conductive pattern 136B on the gate dielectric film 116 and the gate capping pattern 142B covering or on the gate electrode PG may be formed. Then, the gate spacer PGS may be formed on both side walls of the gate structure PGT having a stacked structure of the gate dielectric film 116, the gate electrode PG, and the gate capping pattern 142B, and the ion implantation process for forming a source/drain region in the second active area AC2 may be performed on both sides of the gate structure PGT. In the process, the level of the insulating spacer 172 of the cell array area MCA in the vertical direction Z relative to the lower surface of the substrate 110 may be lowered.

Afterwards, the second capping layer 174, which covers or is on the insulating spacer 172 in the cell array area MCA and covers or is on the gate structure PGT and the gate spacer PGS in the peripheral circuit area PCA, may be formed. Then, the interlayer insulating film 149 filling at least a portion of the peripheral space around the gate structure PGT in the peripheral circuit area PCA may be formed.

In this regard, the insulating spacer 172 may be formed conformally. The insulating spacer 172 may conformally cover the upper surface of the first capping pattern 142A and the buried contact BC.

In some embodiments, as the process of forming the second capping layer 174 is performed after the process of forming the bit lines BL, deterioration of the bit lines BL caused in the process of forming the gate structure PGT and the second capping layer 174 covering or on the gate structure PGT may be prevented or inhibited, which may improve the characteristics of the integrated circuit device 100.

In addition, as the process of forming the gate structure PGT is performed after the annealing process of the buried contacts BC, the heat budget may decrease, and accordingly, the characteristics of the integrated circuit device 100 may be improved.

Moreover, in the process of forming the gate structure PGT, the second capping layer 174 formed in the cell array area MCA may be used as an etching mask in the process for the landing pads LP.

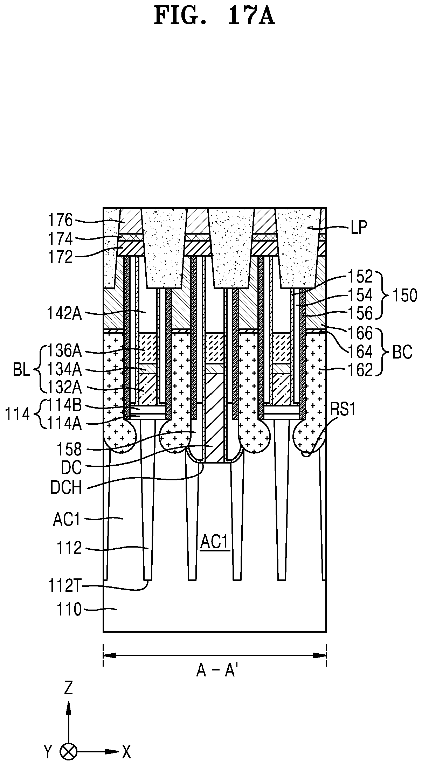

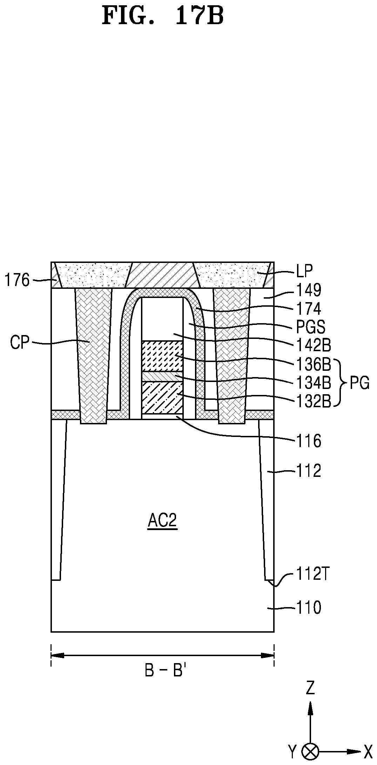

Referring to FIGS. 17A and 17B, by etching the second capping layer 174 and the interlayer insulating film 149 in the peripheral circuit area PCA, the plurality of contact holes CPH exposing the second active area AC2 of the substrate 110 may be formed, and the plurality of contact plugs CP at least partially filling the plurality of contact holes CPH may be formed.

Then, in the cell array area MCA and the peripheral circuit area PCA, the upper insulating layer 176 covering or on the second capping layer 174 may be formed. Afterwards, the landing pad LP passing through or extending into the upper insulating layer 176, the second capping layer 174, and the insulating spacer 172 may be formed. The damascene process may be used as the process of forming the landing pads LP; however, the present disclosure is not limited thereto. The plurality of landing pads LP may be arranged in the shape of an island, ellipse, and/or circle and may be connected to each of the plurality of buried contacts BC.

While the present disclosure has been particularly shown and described with reference to embodiments thereof, it will be understood that various changes in form and details may be made therein without departing from the scope of the following claims.

## Claims

1. A method of manufacturing an integrated circuit device, the method comprising:
providing a substrate (110) comprising a cell array area (MCA) and a peripheral circuit area (PCA);
forming a conductive layer (132, 134, 136) in the cell array area (MCA) and the peripheral circuit area (PCA);
forming a capping insulating layer (142, 144) on the conductive layer (132, 134, 136);
forming, in the cell array area (MCA), a direct contact (DC) and a bit line (BL) by using the capping insulating layer (142, 144) as a first etching mask;
forming a spacer structure (150) on side walls of the direct contact (DC) and on side walls of the bit line (BL);
forming a buried contact (BC) that is between the direct contact (DC) and the bit line (BL) and is on a first side wall of the side walls of the bit line (BL);
forming an insulating spacer (172) on the cell array area (MCA) and the peripheral circuit area (PCA); and
forming, in the peripheral circuit area (PCA), a gate structure (PGT) by using the insulating spacer (172) as a second etching mask.

2. The method of claim 1, wherein forming the capping insulating layer (142, 144) comprises:
forming a first capping layer (142) on the conductive layer (132, 134, 136); and
forming, on the first capping layer (142), a mask layer (144) having an etching selectivity with respect to the first capping layer (142).

3. The method of claim 2, further comprising forming a first capping pattern (142A) and a mask pattern (144A) on each of the direct contact (DC) and the bit line (BL).

4. The method of claim 3, wherein an upper surface of the mask pattern (144A) and an upper surface of the buried contact (BC) are coplanar.

5. The method of claim 4, further comprising removing the mask pattern (144A) to expose the first capping pattern (142A) that is on the bit line (BL), and wherein the insulating spacer (172) has a stepped shape.

6. The method of any one of claims 2 to 5, wherein the first capping layer (142) and the mask layer (144) comprise an oxide, a nitride, an oxynitride, or a combination thereof.

7. The method of any one of claims 1 to 6, further comprising forming a second capping layer (174) that is on the gate structure (PGT) in the peripheral circuit area (PCA) and is on the insulating spacer (172) in the cell array area (MCA).

8. The method of claim 7, further comprising:
forming, in the peripheral circuit area (PCA), a contact plug (CP) on side walls of the gate structure (PGT); and
forming a landing pad (LP) electrically connected to the buried contact (BC) and the contact plug (CP).

9. The method of claim 8, wherein forming the landing pad (LP) comprises:
forming an upper insulating layer (176) on the gate structure (PGT) and the second capping layer (174);
forming a recess (OP2) that extends into the upper insulating layer (176), the second capping layer (174), and the insulating spacer (172); and
forming the landing pad (LP) in the recess (OP2).

10. The method of claim 1, wherein:
forming a capping insulating layer (142, 144) on the conductive layer (132, 134, 136) comprises forming a first capping layer (142) comprising a single film on the conductive layer;
forming, in the cell array area (MCA), the direct contact (DC), the bit line (BL), and a capping pattern (142A) that is on the bit line (BL) and the direct contact (DC) by using the first capping layer (142) as a first etching mask.

11. The method of claim 10, wherein an upper surface of the capping pattern (142A) and an upper surface of the buried contact (BC) are coplanar.

12. The method of claim 10 or 11, further comprising forming a second capping layer (174) that is on the gate structure (PGT) in the peripheral circuit area (PCA) and is on the insulating spacer (172) in the cell array area (MCA).

13. The method of claim 12, further comprising:
forming, in the peripheral circuit area (PCA), a contact plug (CP) on side walls of the gate structure (PGT); and
forming a landing pad (LP) electrically connected to the buried contact (BC) and the contact plug (CP).

14. The method of claim 13, wherein forming the landing pad (LP) comprises:
forming an upper insulating layer (176) on the gate structure (PGT) and the second capping layer (174);
forming a recess (OP2) that extends into the upper insulating layer (176), the second capping layer (174), and the insulating spacer (172); and
forming the landing pad (LP) in the recess (OP2).

15. The method of claim 1, further comprising:
forming a buffer film (114) on the substrate (110);
forming a lower conductive layer (132) on the buffer film (114);
etching the lower conductive layer (132) and the buffer film (114) to define a direct contact hole (DCH);
forming the direct contact (DC) in the direct contact hole (DCH);
forming an intermediate conductive layer (134) on the lower conductive layer (132) and the direct contact (DC);
forming an upper conductive layer (136) on the intermediate conductive layer (134);
forming the first capping layer (142) on the upper conductive layer (136);
forming a mask layer (144) on the first capping layer (142);
patterning the first capping layer (142) and the mask layer (144) to form a mask pattern (144A) and a capping pattern (142A), respectively;
etching, using the mask pattern (144A) and the capping pattern (142A) as a first etching mask:
the upper conductive layer (136), the intermediate conductive layer (134), and the lower conductive layer (132) to form the bit line (BL), and
a portion of the direct contact (DC) to expose a portion of the direct contact hole (DCH);
forming the spacer structure (150) on the portion of the direct contact hole (DCH) and on side walls of the bit line (BL);
removing the mask pattern (144A) to expose the capping pattern (142A); and
forming the insulating spacer (172) on the capping pattern (142A), the spacer structure (150), and the buried contact (BC).
